# EUROPÄISCHE PATENTANMELDUNG

(11) **EP 2 026 011 A2**
(43) Veröffentlichungstag der Anmeldung: **18.02.2009**
(21) Anmeldenummer: 08104912.4
(22) Anmeldetag: 29.07.2008
(51) Int. Cl.: F24C 7/08

(54) **Hausgeräteanordnung**

(30) Priorität: 07.08.2007 DE 102007037301
(71) Anmelder: BSH Bosch und Siemens Hausgeräte GmbH, 81739 München (DE)
(72) Erfinder: Wilsdorf, Gerd, 82140 Olching (DE)

(57) **Zusammenfassung**

Die Erfindung geht aus von einer Hausgeräteanordnung mit einem Schürzenkörper (20), welcher eine Hausgerätesichtfläche (22) bildet, und zumindest einem Betätigungselement (46).

Um eine gattungsgemäße Anordnung mit verbesserten Eigenschaften hinsichtlich einer einfachen Herstellung und eines ansprechenden Designs bereitzustellen, wird vorgeschlagen, dass der Schürzenkörper (20) zumindest eine Ausformung aufweist, die das Betätigungselement (46) bildet.

## Beschreibung

Die Erfindung geht aus von einer Hausgeräteanordnung nach dem Oberbegriff des Anspruchs 1.

Es ist eine Hausgeräteanordnung bekannt, die eine Frontblende aufweist, aus welcher ein Satz von Öffnungen für Betätigungselemente ausgespart ist.

Die Aufgabe der Erfindung besteht insbesondere darin, eine gattungsgemäße Anordnung mit verbesserten Eigenschaften hinsichtlich einer einfachen Herstellung und eines ansprechenden Designs bereitzustellen.

Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einer Hausgeräteanordnung mit einem Schürzenkörper, welcher eine Hausgerätesichtfläche bildet, und zumindest einem Betätigungselement.

Es wird vorgeschlagen, dass der Schürzenkörper zumindest eine Ausformung aufweist, die das Betätigungselement bildet. Dadurch kann eine konstruktiv einfache und optisch ansprechbare Bauweise der Hausgeräteanordnung erreicht werden. In dieser Ausführung ist das Betätigungselement vorteilhafterweise einstückig mit dem Schürzenkörper ausgebildet, wodurch Bauteile und Bauraum eingespart und eine robuste Lagerung des Betätigungselements erreicht werden können. Unter einem "Schürzenkörper" soll in diesem Zusammenhang insbesondere ein Hausgerätebauteil verstanden werden, das eine Hausgerätesichtfläche bildet und eine Bedeckungsfunktion zum Bedecken von Hausgeräteinnenteilen aufweist. Der Schürzenkörper weist zumindest einen Grundbereich auf, der die Funktion einer Bedienblende für eine Hausgerätebedienvorrichtung aufweist. Hierbei ist der Grundbereich relativ zu einem Hausgerätegrundkörper, insbesondere einem vom Hausgerätegrundkörper gebildeten Hausgerätefunktionsraum, wie z.B. einem Garraum, einem Waschraum, einem Kühlraum, einem Spülraum usw. fest gelagert. Das Betätigungselement ist vorzugsweise beweglich relativ zum Grundbereich und es kann mittels einer Bewegung des Betätigungselements eine Hausgerätefunktion ein- bzw. ausgeschaltet werden und/oder es kann ein Hausgerätebetriebsparameter eingestellt werden. Insbesondere ist der Schürzenkörper an einer Hausgerätefrontseite angeordnet, wobei eine vom Schürzenkörper gebildete Hausgerätesichtfläche einer Hausgerätefrontfläche entspricht. Der Schürzenkörper kann beispielsweise einen Grundbereich aufweisen, der als Hausgerätefrontblende ausgebildet ist. Hierbei erstreckt sich der Grundbereich vorteilhafterweise einteilig über zumindest einen wesentlichen Teil, d.h. über zumindest 50 %, bevorzugt über zumindest 75 % einer Erstreckung, d.h. der Länge oder der Breite, der Hausgerätefrontseite. Ferner kann aus dem Grundbereich ein Bereich ausgespart sein, der für eine Anzeigeeinheit und/oder für weitere Betätigungselemente vorgesehen ist. Unter einer "Hausgerätesichtfläche" soll insbesondere eine Fläche verstanden werden, die für einen Endbenutzer eines Hausgeräts unter vorschriftsgemäßen Anwendungsbedingungen sichtbar ist.

Außerdem wird vorgeschlagen, dass der Schürzenkörper einen Grundbereich aufweist und das Betätigungselement als ein sich von dem Grundbereich fortsetzender Steg ausgebildet ist, wodurch eine besonders einfache Konstruktion und ein Betätigungselement mit einem kurzen Hubweg erreicht werden können. Besonders vorteilhaft kann eine federnde Lagerung des Betätigungselements auf eine besonders konstruktiv einfache Weise erreicht werden.

In einer bevorzugten Ausführung der Erfindung wird vorgeschlagen, dass zur Bildung des Betätigungselements zumindest ein Teilbereich aus dem Schürzenkörper ausgespart ist, wodurch eine Material sparende Herstellung erreicht werden kann. In diesem Zusammenhang kann ein einfaches Herstellverfahren erzielt werden, wenn der Teilbereich mittels eines Ausstanzens aus dem Schürzenkörper ausgespart ist.

Außerdem wird vorgeschlagen, dass zur Bildung des Betätigungselements eine Schlitzeinheit aus dem Schürzenkörper ausgespart ist, wodurch eine besonders kompakte Konstruktion erreicht werden kann.

Eine besonders einfache Ausformung des Betätigungselements kann erreicht werden, wenn die Schlitzeinheit zumindest zwei parallele Längsschlitze aufweist. Unter einem "Längsschlitz" soll in diesem Zusammenhang insbesondere ein Schlitz mit einer Längsrichtung verstanden werden, wobei die Erstreckung in Längsrichtung vorteilhaft länger als ein Dreifaches und besonders vorteilhaft länger als ein Fünffaches von dessen Breite ausgebildet ist. Eine vorteilhafte Beweglichkeit des Betätigungselements kann erreicht werden, wenn die Schlitze in einer Richtung offen ausgebildet sind.

Ferner wird vorgeschlagen, dass der Schürzenkörper zumindest zwei Betätigungselemente bildet und die Schlitzeinheit einen die Betätigungselemente trennenden Schlitz aufweist, wobei eine Hausgeräteanordnung mit einer Gruppe von benachbarten Betätigungselementen besonders einfach hergestellt werden kann.

Eine weitere Bauraumeinsparung kann vorteilhaft erreicht werden, wenn der ausgesparte Teilbereich sich an einen für eine Anzeigeinheit ausgesparten Anzeigebereich anschließt.

Ferner wird vorgeschlagen, dass der Schürzenkörper sich in einer Hausgerätegrundeinbaustellung über zumindest einen wesentlichen Teil einer Hausgerätefrontseite in vertikaler Richtung erstreckt, wodurch ein Einsparen von weiteren Bauteilen und Montageschritten sowie eine robuste Ausführung der Hausgeräteanordnung vorteilhaft erreicht werden kann. Unter einer "Hausgerätegrundeinbaustellung" soll insbesondere eine Stellung verstanden werden, die bei einer Anwendung eines Hausgeräts, in welchem die Hausgeräteanordnung eingesetzt ist, unter üblichen bzw. vorschriftsgemäßen Anwendungsbedingungen vorliegt. Hier und im gesamten Text beziehen sich die Begriffe "horizontal", "vertikal", "oben", "unten", "seitlich" usw. auf die Ausrichtung der Hausgeräteanordnung bei einer Hausgerätegrundeinbaustellung. Ferner soll unter "zumindest einem wesentlichen Teil" insbesondere zumindest 50 %, vorteilhaft zumindest 75 % und bevorzugt zumindest 90 % verstanden werden.

In einer weiteren Ausführung der Erfindung wird vorgeschlagen, dass der Schürzenkörper zumindest einen Teilbereich aufweist, der als Rahmeneinheit zum zumindest teilweisen Umrahmen eines Hausgerätetürbereichs ausgebildet ist, wodurch eine zusätzliche Schutzfunktion des Schürzenkörpers erreicht werden kann. Hierbei grenzt der Schürzenkörper vorzugsweise an zumindest drei Seiten des Hausgerätetürbereichs an. Insbesondere kann der Schürzenkörper eine U-Form aufweisen.

Es kann ferner ein hoher Bedienkomfort, insbesondere eine vorteilhafte Übersichtlichkeit der Funktionalitäten einer Hausgerätebedienvorrichtung erreicht werden, wenn das Betätigungselement eine Breite aufweist, die zumindest ein Dreißigstel der Schürzenkörperbreite beträgt.

Ferner wird vorgeschlagen, dass die Hausgeräteanordnung eine Lichtsignaleinheit mit einem Leuchtbereich aufweist, welcher dem Betätigungselement zugeordnet ist, wodurch der Bedienkomfort weiter erhöht werden kann.

In diesem Zusammenhang kann eine hohe Sichtbarkeit des Leuchtbereichs erreicht werden, wenn der Leuchtbereich als ein länglicher Bereich ausgebildet ist, der sich über zumindest einen wesentlichen Teil einer Betätigungselementskante erstreckt. Hierbei erstreckt sich der längliche Leuchtbereich parallel zur Betätigungselementskante insbesondere über zumindest 50 %, vorteilhaft über zumindest 75 % und besonders bevorzugt über zumindest 90 % der Erstreckung der Betätigungselementskante.

Besonders vorteilhaft weist die Hausgeräteanordnung eine Schutzeinheit zum Schützen des Betätigungselements auf, wie z.B. einen Schutzrahmen, die den Leuchtbereich bildet, wodurch Bauteile und Bauraum vorteilhaft eingespart werden können. Diese Schutzeinheit ist vorzugsweise aus einem lichtdurchlässigen Material, wie z.B. Plexiglas oder lichtdurchlässigem Silikon, hergestellt. Vorteilhafterweise kann die Hausgeräteanordnung eine Lichtquelleneinheit aufweisen, die zum Hinterleuchten der Schutzeinheit vorgesehen ist.

Eine robuste und langlebige Hausgeräteanordnung kann ferner erreicht werden, wenn der Schürzenkörper aus Metall hergestellt ist. Ein optisch ansprechbarer Schürzenkörper kann ferner erreicht werden, wenn der Schürzenkörper zumindest aus einem Edelmetall hergestellt ist.

In einer weiteren Ausführung der Erfindung wird vorgeschlagen, dass der Schürzenkörper zumindest zwei Betätigungselemente bildet und einen Aufnahmebereich zur Aufnahme eines Bedienmittels aufweist, welcher zwischen den Betätigungselementen angeordnet ist, wodurch weitere Funktionalitäten der Hausgeräteanordnung auf kompakte Weise erreicht werden können. Hierbei ist der Aufnahmebereich "zwischen" zwei Betätigungselementen angeordnet, wenn es zumindest ein einen Punkt des ersten Betätigungselements und einen Punkt des zweiten Betätigungselements verbindendes Geradesegment gibt, das den Aufnahmebereich an zumindest einer Stelle schneidet, die zwischen den Punkten angeordnet ist.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Hausgerät in einer Frontansicht mit einem Schürzenkörper, wel- cher ein Betätigungselement bildet,
- Fig. 2: den Schürzenkörper in einer Frontansicht und
- Fig. 3: eine Detailansicht eines Betätigungselements aus Figur 1.

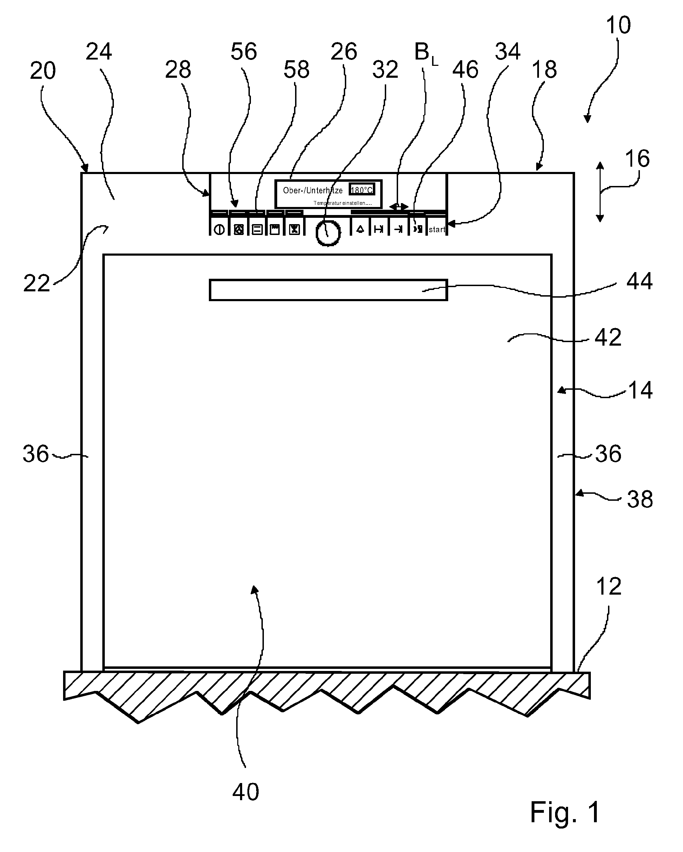

Figur 1 zeigt ein als Gargerät, und zwar als Backofen, ausgebildetes Hausgerät 10 in einer Frontansicht. Das Hausgerät 10 ist in Figur 1 in dessen Grundeinbaustellung gezeigt, bei welcher es sich auf einer horizontalen Abstellfläche 12 abstützt. Das Hausgerät 10 weist eine Hausgerätefrontseite 14 auf, die in der Grundeinbaustellung im Wesentlichen in vertikaler Richtung 16 ausgerichtet ist und einer das Hausgerät 10 unter vorschriftsgemäßen Bedingungen bedienenden Person zugewandt ist. Das Hausgerät 10 weist eine Hausgeräteanordnung 18 auf, die auf der Hausgerätefrontseite 14 angeordnet ist. Die Hausgeräteanordnung 18 umfasst einen Schürzenkörper 20, der eine für einen Endbenutzer des Hausgeräts 10 sichtbare Hausgerätesichtfläche 22 bildet, die in der Hausgerätegrundeinbaustellung vertikal ausgerichtet ist. Der Schürzenkörper 20 ist mittels nicht näher dargestellter Befestigungselemente an einem Hausgerätegrundkörper befestigt, welcher einen Hausgerätefunktionsraum, wie im betrachteten Fall einen Garraum, bildet.

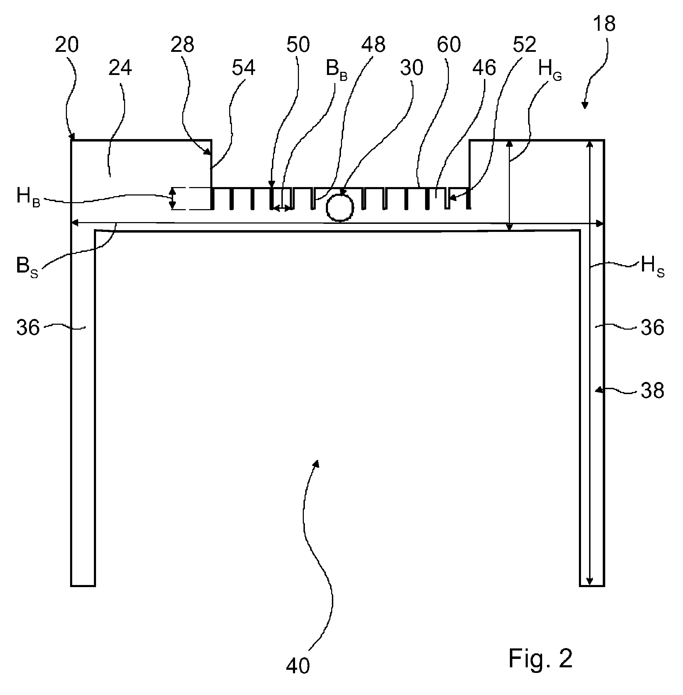

Die Beschreibung des Schürzenkörpers 20 bezieht sich ebenfalls auf Figur 2, die den vom Hausgerätegrundkörper getrennten Schürzenkörper 20 in einer Frontansicht darstellt. Der Schürzenkörper 20 weist einen Grundbereich 24 auf, welcher als Hausgerätefrontblende dient. Der Grundbereich 24 erstreckt sich in der Hausgerätegrundeinbaustellung in horizontaler Richtung über die Breite der Hausgerätefrontseite 14. Der Grundbereich 24 weist als Hausgerätefrontblende eine Bedeckungsfunktion auf und bedeckt insbesondere elektrische bzw. elektronische Bauteile des Hausgeräts 10, wie z.B. Schaltelemente, in horizontaler Richtung. Ferner weist der Schürzenkörper 20 eine Ausbuchtung auf, die einen für eine Anzeigeeinheit 26 vorgesehenen Anzeigebereich 28 bildet. Insbesondere ist der Anzeigebereich 28 aus dem Schürzenkörper 20 ausgespart, und zwar mittels eines Trennverfahrens, wie insbesondere mittels eines Ausstanzens. Der Anzeigebereich 28 ist in vertikaler Richtung 16 nach oben offen ausgebildet und bezüglich der Breite der Hausgerätefrontseite 14 in dieser Hausgerätefrontseite 14 mittig angeordnet. Hierbei ist der Anzeigebereich 28 durch den Schürzenkörper 20 umgriffen. Die Anzeigeeinheit 26 ist als LCD-Display ausgebildet, das zur Anzeige von Symbolen und/oder Klartextanzeigen dient. Der Schürzenkörper 20 bildet ferner einen Aufnahmebereich 30, der kreisförmig ausgebildet ist und zur Aufnahme eines als Knebelgriff ausgebildeten Bedienmittels 32 einer Betätigungseinheit 34 des Hausgeräts 10 dient.

Der Schürzenkörper 20 ist als ein einteiliger Körper aus Blech, insbesondere einem mit zumindest einem Edelmetall hergestellten Blech, ausgebildet und weist eine U-Form auf. Hierbei weist der Schürzenkörper 20 zwei längliche, sich in vertikaler Richtung 16 erstreckende Teilbereiche 36 auf, die sich jeweils an den Grundbereich 24 einteilig anschließen. Die Teilbereiche 36 und der Grundbereich 24 bilden im Zusammenwirken einen Teilbereich des Schürzenkörpers 20, der als Rahmeneinheit 38 zum Umrahmen eines Hausgerätetürbereichs 40 ausgebildet ist. Im Hausgerätetürbereich 40 befindet sich eine Hausgerätetür 42, die mittels eines Türgriffs 44 durch einen Bediener zu einer Schwenkbewegung betätigbar ist. Die Hausgerätetür 42 in deren Schließposition verschließt einen Hausgerätefunktionsraum, der im betrachteten Beispiel als Garraum ausgebildet ist. Die Hausgerätetür 42 ist mit einem Hausgerätefenster versehen, das ein durchsichtiges Glas aufweist, durch welches ein Bediener einen im Hausgerätefunktionsraum durchgeführten Hausgerätefunktionsbetrieb, wie insbesondere einen Garbetrieb, beobachten kann. Der Hausgerätetürbereich 40, welcher durch den Schürzenkörper 20 begrenzt ist, ist in vertikaler Richtung 16 nach unten offen ausgebildet. Hierbei bildet der Grundbereich 24, der in vertikaler Richtung 16 oberhalb des Hausgerätetürbereichs 40 angeordnet ist, die obere Grenze des Hausgerätetürbereichs 40 und die vertikalen Teilbereiche 36, die zueinander parallel ausgerichtet sind, bilden die seitlichen Grenzen des Hausgerätetürbereichs 40. Somit sind die Teilbereiche 36 an beiden Seiten von dem Hausgerätetürbereich 40 angeordnet. Der Hausgerätetürbereich 40 ist hiermit mittels des Grundbereichs 24 und der vertikalen Teilbereiche 36 teilweise umrahmt. Der Schürzenkörper 20 erstreckt sich in vertikaler Richtung 16 im Bereich der seitlichen Kanten der Hausgerätefrontseite 14 über die Höhe der Hausgerätefrontseite 14. Hierbei erstrecken sich die Teilbereiche 36 ausgehend vom Grundbereich 24 gerade bis zur unteren Kante der Hausgerätefrontseite 14. In einer alternativen Ausführung des Hausgeräts 10, wie z.B. als Spülmaschine, ist die Ausbildung des Schürzenkörpers 20 als ein sich über die gesamte Hausgerätefrontseite 14 erstreckendes Bauteil denkbar.

Die Hausgeräteanordnung 18 weist ferner eine Mehrzahl von Betätigungselementen 46 auf, die mit dem Bedienmittel 32 die Betätigungseinheit 34 bilden. Die Betätigungselemente 46 sind jeweils als Tasten ausgebildet, die zur Aktivierung einer Hausgerätefunktion durch einen Endbediener vorgesehen sind. Vorzugsweise ist den Tasten jeweils eine unterschiedliche Funktion zugeordnet. Hierbei sind Funktionssymbole vorgesehen, die jeweils an die Frontfläche eines der Betätigungselemente 46 angebracht sind, wie z.B. mittels eines Druckvorgangs. Die Betätigungselemente 46 sind in zwei Gruppen verteilt, die in horizontaler Richtung beidseitig vom Aufnahmebereich 30 und jeweils in horizontaler Reihe angeordnet sind. Hiermit ist der Aufnahmebereich 30 in horizontaler Richtung zwischen den Gruppen von Betätigungselementen 46 angeordnet. Die Betätigungselemente 46 und der Aufnahmebereich 30 befinden sich in vertikaler Richtung 16 unterhalb des Anzeigebereichs 28.

Die Betätigungselemente 46 sind jeweils als Ausformungen des Schürzenkörpers 20 ausgebildet. Insbesondere sind die Betätigungselemente 46 jeweils als ein sich vom Grundbereich 24 vertikal nach oben fortsetzender Steg ausgeführt. Somit sind die Betätigungselemente 46 mit dem Grundbereich 24 einstückig ausgebildet. Die Frontfläche des Grundbereichs 24 und die Frontfläche einer der Betätigungselemente 46 bilden jeweils einen kontinuierlichen Übergang. Alternativ ist denkbar, dass diese Frontflächen eine Stufe bilden. Die Betätigungselemente 46 sind in horizontaler Richtung vom Grundbereich 24 bzw. von einem direkt benachbarten Betätigungselement 46 mittels eines Schlitzes 48 einer Schlitzeinheit 50 getrennt. Die Schlitzeinheit 50 weist hierbei eine Mehrzahl von Schlitzen 48 auf. Diese Schlitze 48 sind jeweils als ein Längsschlitz ausgebildet, welcher sich ausgehend vom Grundbereich 24 in vertikaler Richtung 16 nach oben erstreckt. Ferner sind die Schlitze 48 der Schlitzeinheit 50 zueinander parallel ausgerichtet. Die Schlitze 48 sind außerdem in vertikaler Richtung 16 nach oben offen ausgebildet, so dass ein durch diesen Schlitz 48 gebildeter Zwischenraum zwischen zwei benachbarten Betätigungselementen 46 bzw. zwischen einem Betätigungselement 46 und dem Grundbereich 24 sich an den für die Anzeigeeinheit 26 vorgesehenen Anzeigebereich 28 anschließt. Die Schlitzeinheit 50 entspricht einem Teilbereich 52, welcher bei einer Herstellung der Hausgeräteanordnung 18 aus dem Schürzenkörper 20 zur Bildung der Betätigungselemente 46 ausgespart ist. In einem Herstellvorgang werden der Anzeigebereich 28, die Schlitzeinheit 50 und ggf. der Aufnahmebereich 30 mittels eines Trennverfahrens, und zwar mittels eines Ausstanzens, aus dem Schürzenkörper 20, der als Blechstück ausgebildet ist, ausgespart. Das Ausstanzen des Anzeigebereichs 28 kann getrennt von dem Ausstanzvorgang zur Bildung der Schlitzeinheit 50 erfolgen oder es können in einem gleichen Ausstanzvorgang der Anzeigebereich 28 und die Schlitzeinheit 50 ausgespart werden. Wie oben beschrieben schließt sich der zur Bildung der Betätigungselemente 46 dienende Teilbereich 52 an den Anzeigebereich 28 an. Insbesondere weist der Grundbereich 24 eine geradlinige Kante 54 auf, welche eine seitliche Grenze des Anzeigebereichs 28 bildet, wobei diese geradlinige Kante 54 sich kontinuierlich in vertikaler Richtung 16 nach unten als eine einen Schlitz 48 begrenzende Kante fortsetzt.

Der als Hausgerätefrontblende dienende Grundbereich 24 weist in vertikaler Richtung 16, ausgehend von der oberen Kante des Schürzenkörpers 20 bis zur oberen Grenze des Hausgerätetürbereichs 40, eine Höhe H_{G} auf. Der Anzeigebereich 28 erstreckt sich in vertikaler Richtung 16 über eine Strecke, die der Hälfte H_{G} /2 der Höhe H_{G} beträgt. Hiermit sind die Betätigungselemente 46 und der Aufnahmebereich 30 in der unteren Hälfte der durch den Grundbereich 24 gebildeten Hausgerätefrontblende angeordnet. Hierbei ist die untere Hälfe des Grundbereichs 24 unterhalb einer gedachten Linie, die horizontal verläuft und mit einem Abstand von H_{G} /2 von der oberen Kante des Schürzenkörpers 20 angeordnet. Die als Metallzungen ausgebildeten Betätigungselemente 46 weisen eine Erstreckung in vertikaler Richtung 16 auf, die einer Höhe H_{B} von H_{G} /4 entspricht. Hiermit ist unterhalb der Betätigungselemente 46 ein zusammenhängender Teilbereich des Grundbereichs 24 angeordnet, der eine Höhe von H_{G} /4 aufweist. Der Schürzenkörper 20 weist im Bereich seiner seitlichen Kanten eine Schürzenkörperhöhe H_{S} auf, d.h. eine Erstreckung in vertikaler Richtung 16, die einer Höhe von einem Mehrfachen, insbesondere einem Sechsfachen der Höhe H_{G} entspricht. Hierbei entspricht die Länge, d.h. die vertikale Erstreckung, der Teilbereiche 36 einem Fünffachen der Höhe H_{G}.

Der Schürzenkörper 20, und zwar der Grundbereich 24, weist eine Schürzenkörperbreite B_{S}, d.h. eine Erstreckung in horizontaler Richtung, auf. Der Anzeigebereich 28 weist eine Erstreckung in horizontaler Richtung auf, die eine Länge von zumindest 40 % der Schürzenkörperbreite B_{S} beträgt. Die Betätigungselemente 46 zusammen mit dem Aufnahmebereich 30 bilden eine Baugruppe, die sich über die Länge des Anzeigebereichs 28 erstreckt. Die als Tasten ausgebildeten Betätigungselemente 46 weisen eine Breite B_{B}, d.h. eine Erstreckung in horizontaler Richtung auf, die zumindest einer Länge von B_{S}/30 entspricht. Insbesondere weisen die Betätigungselemente 46 eine Breite B_{B} von zumindest 22 mm auf.

Die Hausgeräteanordnung 18 ist ferner mit einer Lichtsignaleinheit 56 versehen. Diese weist eine Mehrzahl von Leuchtbereichen 58 auf, wobei ein Leuchtbereich 58 jeweils einem unterschiedlichen Betätigungselement 46 zugeordnet ist. Diese Leuchtbereiche 58, die jeweils in vertikaler Richtung 16 oberhalb eines der Betätigungselemente 46 angeordnet sind, sind jeweils als ein länglicher Bereich ausgebildet, welcher eine Haupterstreckungsrichtung in horizontaler Richtung aufweist. Hierbei erstreckt sich ein Leuchtbereich 58 parallel zur oberen Betätigungselementskante 60 eines Betätigungselements 46. Insbesondere weist ein Leuchtbereich 58 eine Längserstreckung B_{L} auf, die der Breite B_{B} des zugeordneten Betätigungselements 46 entspricht. Die Hausgeräteanordnung 18 weist eine Lichtquelleneinheit und eine Steuereinheit auf, die im Zusammenwirken mit der Lichtquelleneinheit dazu vorgesehen ist, bei der Betätigung eines Betätigungselements 46 den dem Betätigungselement 46 entsprechenden Leuchtbereich 58 zu beleuchten. Die Leuchtbereiche 58 sind jeweils relativ zum Grundbereich 24 fest angeordnet. Eine Anordnung der Leuchtbereiche 58 an den Betätigungselementen 46 ist ebenfalls denkbar.

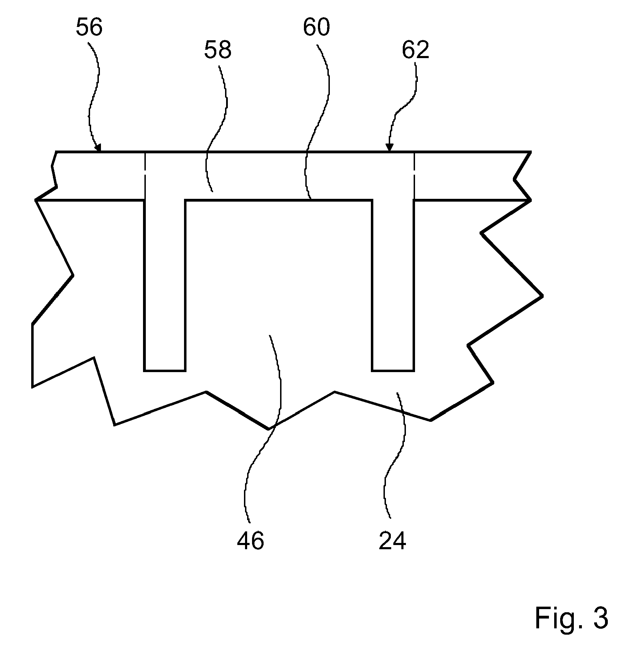

Wie der Figur 3 zu entnehmen ist, in welcher eine Detailansicht eines Betätigungselements 46 dargestellt ist, sind die Leuchtbereiche 58 von einer Schutzeinheit 62 gebildet, die zum Schutz der Betätigungselemente 46 dient. Im betrachteten Beispiel bildet die Schutzeinheit 62 einen Schutzrahmen, der die Betätigungselemente 46 teilweise umrahmt. Hierbei entspricht ein Leuchtbereich 58 einem Teilbereich der Schutzeinheit 62, der oberhalb der oberen Betätigungselementskante 60 angeordnet ist. Es ist denkbar, dass der gesamte Teilbereich, welcher das Betätigungselement 46 teilweise umrahmt, als Leuchtbereich ausgebildet ist. Die Leuchtbereiche 58 können von einem Bauteil aus lichtdurchlässigem Material, wie z.B. einem Bauteil aus Plexiglas, gebildet sein. Alternativ oder zusätzlich kann die Schutzeinheit einen Schutzkörper aus Silikon, vorzugsweise einem lichtdurchlässigen Silikon, aufweisen. Es kann beispielsweise bei der Aktivierung einer Hausgerätefunktion mittels eines Betätigungselements 46 ein Silikonstreifen entlang der entsprechenden oberen Betätigungselementskante 60 und/oder Silikonstreifen entlang der seitlichen Betätigungselementskanten von der Lichtquelleneinheit hinterleuchtet werden.

Die Betätigungselemente 46, die jeweils als Steg ausgeführt sind und hiermit über deren Basis mit dem Grundbereich 24 zusammenhängen, sind als Federelemente ausgebildet. Bei einer Betätigung, d.h. bei einem Drücken, eines Betätigungselements 46, ausgehend von einer Anfangsposition, fährt dieses bei einem Loslassen automatisch in dessen Anfangsposition zurück. Bei der durch das Drücken ausgelösten Bewegung des Betätigungselements 46 relativ zum Grundbereich 24, wird vom Betätigungselement 46 ein hinter dem Betätigungselement 46 angeordneter und in den Figuren nicht gezeigter Schalter betätigt, welcher mit einer nicht gezeigten elektrischen Steuereinheit zur Einschaltung der entsprechenden Hausgerätefunktion in Wirkverbindung steht. Aufgrund des geringen Verstellwegs der Betätigungselemente 46 sind die Schalter jeweils als Kurzhubschalter ausgebildet.

### Bezugszeichen

- 10: Hausgeräte
- 12: Abstellfläche
- 14: Hausgerätefrontseite
- 16: vertikale Richtung
- 18: Hausgeräteanordnung
- 20: Schürzenkörper
- 22: Hausgerätesichtfläche
- 24: Grundbereich
- 26: Anzeigeeinheit
- 28: Anzeigebereich
- 30: Aufnahmebereich
- 32: Bedienmittel
- 34: Betätigungseinheit
- 36: Teilbereich
- 38: Rahmeneinheit
- 40: Hausgerätetürbereich
- 42: Hausgerätetür
- 44: Türgriff
- 46: Betätigungselement
- 48: Schlitz
- 50: Schlitzeinheit
- 52: Teilbereich
- 54: Kante
- 56: Lichtsignaleinheit
- 58: Leuchtbereich
- 60: Betätigungselementskante
- 62: Schutzeinheit
- H_{G}: Höhe
- H_{B}: Höhe
- H_{S}: Schürzenkörperhöhe
- B_{S}: Schürzenkörperbreite
- B_{B}: Breite
- B_{L}: Erstreckung

## Patentansprüche

1. Hausgeräteanordnung mit einem Schürzenkörper (20), welcher eine Hausgerätesichtfläche (22) bildet, und zumindest einem Betätigungselement (46), **dadurch gekennzeichnet, dass** der Schürzenkörper (20) zumindest eine Ausformung aufweist, die das Betätigungselement (46) bildet.

2. Hausgeräteanordnung nach Anspruch 1, **dadurch gekennzeichnet, dass** der Schürzenkörper (20) einen Grundbereich (24) aufweist und das Betätigungselement (46) als ein sich von dem Grundbereich (24) fortsetzender Steg ausgebildet ist.

3. Hausgeräteanordnung nach Anspruch 1 oder 2, **dadurch gekennzeichnet, dass** zur Bildung des Betätigungselements (46) zumindest ein Teilbereich (52) aus dem Schürzenkörper (20) ausgespart ist.

4. Hausgeräteanordnung nach Anspruch 3, **dadurch gekennzeichnet, dass** eine Schlitzeinheit (50) aus dem Schürzenkörper (20) zur Bildung des Betätigungselements (46) ausgespart ist.

5. Hausgeräteanordnung nach Anspruch 4, **dadurch gekennzeichnet, dass** die Schlitzeinheit (50) zumindest zwei parallele Längsschlitze (48) aufweist.

6. Hausgeräteanordnung nach einem der Ansprüche 4 oder 5, **dadurch gekennzeichnet, dass** der Schürzenkörper (20) zumindest zwei Betätigungselemente (46) bildet und die Schlitzeinheit (50) einen die Betätigungselemente (46) trennenden Schlitz (48) aufweist.

7. Hausgeräteanordnung nach einem der Ansprüche 3 bis 6, **dadurch gekennzeichnet, dass** der ausgesparte Teilbereich (52) sich an einen für eine Anzeigeinheit (26) vorgesehenen Anzeigebereich (28) anschließt.

8. Hausgeräteanordnung nach einem der vorhergehenden Ansprüche, **dadurch gekennzeichnet, dass** der Schürzenkörper (20) sich in einer Hausgerätegrundeinbaustellung über zumindest einen wesentlichen Teil einer Hausgerätefrontseite (14) in vertikaler Richtung (16) erstreckt.

9. Hausgeräteanordnung nach einem der vorhergehenden Ansprüche, **dadurch gekennzeichnet, dass** der Schürzenkörper (20) zumindest einen Teilbereich aufweist, der als Rahmeneinheit (38) zum zumindest teilweisen Umrahmen eines Hausgerätetürbereichs (40) ausgebildet ist.

10. Hausgeräteanordnung nach einem der vorhergehenden Ansprüche, **dadurch gekennzeichnet, dass** das Betätigungselement (46) eine Breite (B_{B}) aufweist, die zumindest ein Dreißigstel der Schürzenkörperbreite (B_{S}) beträgt.

11. Hausgeräteanordnung nach einem der vorhergehenden Ansprüche, **gekennzeichnet durch** eine Lichtsignaleinheit (56) mit zumindest einem Leuchtbereich (58), welcher dem Betätigungselement (46) zugeordnet ist.

12. Hausgeräteanordnung nach Anspruch 11, **dadurch gekennzeichnet, dass** der Leuchtbereich (58) als ein länglicher Bereich ausgebildet sich, der sich über zumindest einen wesentlichen Teil einer Betätigungselementskante (60) erstreckt.

13. Hausgeräteanordnung nach Anspruch 11 oder 12, **gekennzeichnet durch** eine Schutzeinheit (62) zum Schützen des Betätigungselements (46), die den Leuchtbereich (58) bildet.

14. Hausgeräteanordnung nach einem der vorhergehenden Ansprüche, **dadurch gekennzeichnet, dass** der Schürzenkörper (20) aus Metall hergestellt ist.

15. Hausgeräteanordnung nach einem der vorhergehenden Ansprüche, **dadurch gekennzeichnet, dass** der Schürzenkörper (20) zumindest zwei Betätigungselemente (46) bildet und einen Aufnahmebereich (30) zur Aufnahme eines Bedienmittels (32) aufweist, welcher zwischen den Betätigungselementen (46) angeordnet ist.

16. Hausgerät mit einer Hausgeräteanordnung nach einem der vorhergehenden Ansprüche.
